(19) Europäisches Patentamt
European Patent Office
Office européen des brevets

(11) **EP 2 513 659 B1**

(12) **EUROPÄISCHE PATENTSCHRIFT**

(45) Veröffentlichungstag und Bekanntmachung des Hinweises auf die Patenterteilung:
**12.10.2016 Patentblatt 2016/41**

(21) Anmeldenummer: **10773055.8**

(22) Anmeldetag: **28.10.2010**

(51) Int Cl.:
***G01R 31/36*** *(2006.01)*

(86) Internationale Anmeldenummer:
**PCT/EP2010/066343**

(87) Internationale Veröffentlichungsnummer:
**WO 2011/079977 (07.07.2011 Gazette 2011/27)**

(54) **VERFAHREN ZUR ERMITTLUNG DES LADEZUSTANDS EINES BATTERIEPACKS**

METHOD FOR DETERMINING THE CHARGE STATE OF A BATTERY PACK

PROCÉDÉ POUR DÉTERMINER L'ÉTAT DE CHARGE D'UN BLOC-BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.12.2009 DE 102009054924**

(43) Veröffentlichungstag der Anmeldung:
**24.10.2012 Patentblatt 2012/43**

(73) Patentinhaber:
• **Samsung SDI Co., Ltd.**
**Gyeonggi-do (KR)**
• **Robert Bosch GmbH**
**70442 Stuttgart (DE)**

(72) Erfinder:
• **BOEHM, Andre**
**70806 Kornwestheim (DE)**
• **SOBOLL, Stefan**
**70469 Stuttgart (DE)**
• **GAEBLER, Sven**
**70499 Stuttgart (DE)**

(74) Vertreter: **Bee, Joachim et al**
**Robert Bosch GmbH**
**Zentalabteilung Patente**
**Postfach 30 02 20**
**70442 Stuttgart (DE)**

(56) Entgegenhaltungen:
**KR-A- 20010 059 122      US-A1- 2006 091 863**
**US-A1- 2009 189 613**

EP 2 513 659 B1

**Beschreibung**

Stand der Technik

Die Erfindung geht aus von einem Verfahren zur Ermittlung des Ladezustandes eines Batteriepacks, welches aus mehreren Einzelbatteriezellen besteht. Gegenstand der vorliegenden Erfindung sind auch ein Batteriesystem bestehend aus einem Li-Ionenbatteriepack und einem Batteriemanagementsystem, welches nach obigen Verfahren arbeitet sowie ein Kraftfahrzeug, welches ein Batteriesystem bestehend aus einem Li-Ionenbatteriepack und ein entsprechendes Batteriemanagementsystem beinhaltet. Ferner ist ein Computerprogramm Gegenstand der Erfindung, das alle Schritte des erfindungsgemäßen Verfahrens ausführt, wenn es auf einem Rechengerät abläuft.

In vielfältigen Anwendungen, wie z.B. in Hybrid- oder Elektrofahrzeugen, wird elektrische Energie, die in einer Batterie gespeichert ist, als Energiequelle verwendet. Für den Betrieb einer solchen Batterie ist es dabei entscheidend, feststellen zu können, in welchem Zustand die Batterie ist und welche Kapazität sie für den weiteren Betrieb hat. Dazu wird der Betrieb der Batterie mittels eines Batteriemanagementsystems BMS verwaltet. Dieses Batteriemanagementsystem ermittelt unter anderem für jede einzelne Zelle den Ladezustand SOC oder "State-of-Charge". Der Ladezustand kann dabei zwischen vollständiger Entladung und vollständiger Aufladung variieren.

In Hybrid- und Elektrofahrzeugen werden Batteriepacks in Li-Ionen oder NiMH-Technologie eingesetzt, die aus einer großen Anzahl in Serie und oder parallel geschalteten elektrochemischen Zellen bestehen. Das Batteriemanagementsystem dient zur Überwachung der Batterie und soll neben der Sicherheitsüberwachung eine möglichst hohe Lebensdauer gewährleisten.

Die Ladezustände der einzelnen Batteriezellen können sich innerhalb des Batteriepacks unter Umständen wesentlich unterscheiden. Von übergeordneten Steuergeräten oder zur Ladezustandsanzeige für den Benutzer wird allerdings die Angabe eines einzelnen, aussagekräftigen und repräsentativen Ladezustandswertes gefordert.

Aus dem Stand der Technik ist bekannt, den Mittelwert der Ladezustände der einzelnen Batteriezellen auszugeben. Hierbei besteht das Problem, dass einzelne Zellen überladen werden könnten, wenn der mittlere Ladezustand noch unterhalb von 100%, also unterhalb des maximalen Ladezustands bei vollständiger Aufladung liegt. Ebenso können einzelne Zellen unterladen werden, wenn der mittlere SOC noch oberhalb 0%, also oberhalb des minimalen Ladezustands bei vollständiger Entladung liegt. Nachteilig ist dabei, dass es bei Unter- oder Überladung von elektrochemischen Batteriezellen zu einer beschleunigten Alterung oder aber zu einer Schädigung der Batteriezellen kommen kann. Im Extremfall kann es zum Brand oder zu Explosion der Batterie kommen.

Ferner ist bekannt, den Maximal- und Minimalwert der einzelnen Batteriezellen anzugeben. Durch Auswertung beider Werte können Über- und Unterladung vermieden werden. Allerdings ist die Handhabung zweier Werte mit Komplikationen verbunden, wie zum Beispiel bei der Anzeige des Gesamtladezustands oder bei der Anzeige oder Ermittlung der Restladedauer oder der verfügbaren Kapazität. Beim Übergang von einem auf den anderen Wert sind darüber hinaus Sprünge unvermeidlich.

Des Weiteren ist bekannt, für hohe Ladezustände den Maximalwert der Einzelbatteriezellen und für niedrige Ladezustände den Minimalwert der Einzelbatteriezellen auszugeben. Hierbei ist jedoch von Nachteil, dass der Batteriepackladezustand am Schwellwert diskontinuierlich springt, was zu unberechenbarem oder nicht vollziehbarem Verhalten oder springenden Ladezustandsanzeigen führen kann.

Aus der US 2009/0189613 A1 ist ein Verfahren für eine Zustandsbestimmung einer Batteriezelle bekannt, wobei anhand von Sensoren mindestens eine Spannung, ein Strom oder eine Temperatur einer Batteriezelle gemessen wird. Anhand der gemessenen Spannung, des Stromes oder der Temperatur der Batteriezelle wird die Zustandsbestimmung zu einen vorgegebenen Zeitpunkt durchgeführt und der Zustand der Batteriezelle in einem Speicher gespeichert.

Aus der US 2006/0091863 ist ein Batterie-Steuermodul einer Batterie bekannt, das ein Modul zur Erfassung einer Batteriespannung, ein Modul zur Erfassung eines Batteriestromes und ein Modul zur Bestimmung eines Ladezustands der Batterie umfasst, wobei das Modul zur Bestimmung des Ladezustands der Batterie mit den Modulen zur Erfassung der Batteriespannung und zur Erfassung des Batteriestromes kommuniziert. In einer Ausführungsform ermittelt das Modul zur Bestimmung des Ladezustands der Batterie einen ungefilterten Ladezustand der Batterie und Merkmale des ungefilterten Ladezustands, wobei aus dem ungefilterten Ladezustand und den Merkmalen des ungefüterten Ladezustands ein Ladezustand der Batterie ermittelt wird.

Offenbarung der Erfindung

Erfindungsgemäß wird ein Verfahren zur Ermittlung des Ladezustands eines Batteriepacks bestehend aus einer Anzahl "N" von einzelnen Batteriezellen vorgeschlagen, welches die folgenden Schritte umfasst: Zunächst wird der Ladezustand jeder einzelnen Batteriezelle $SOC_i$ für alle i=1,N bestimmt, wobei der Batterieladezustand zwischen einem minimalen Ladezustand der vollständigen Entladung $SOC_{min}$ und einem maximalen Ladezustand der vollständigen Aufladung $SOC_{max}$ variiert. In einem zweiten Schritt wird der Mittelwert der Ladezustände der einzelnen Batte-

riezellen mean($SOC_i$) bestimmt. Es folgt das Bestimmen einer Gewichtung "w" des maximalen Batterieladezustandes einer Batteriezelle des Batteriepacks max($SOC_i$) bzw. einer Gewichtung (1-w) des minimalen Batterieladezustandes einer Batteriezelle des Batteriepacks (min($SOC_i$)) aus der Gleichung mit w = gw(mean($SOC_i$)), wobei für die Funktion gw(SOC) gilt:

    1. der Funktionswert strebt gegen einen Minimalwert von $w_{min}$, wenn sein Argument gegen den minimalen Lade-zustand der vollständigen Entladung $SOC_{min}$ strebt;

    2. der Funktionswert strebt gegen einen Maximalwert von $w_{max}$, wenn sein Argument gegen den maximalen Lade-zustand der vollständigen Aufladung $SOC_{max}$ strebt; und

    3. die Funktion gw() ist stetig.

Abschliessend wird der Ladezustands des gesamten Batteriepacks $SOC_p$ als Funktion des Wertes der Gewichtung w, des maximalen Batterieladezustands einer Batteriezelle des Batteriepacks max($SOC_i$) und des minimalen Batterieladezustands einer Batteriezelle des Batteriepacks min ($SOC_i$) berechnet, gemäß der Gleichung:

$$SOC_p = w/(w_{max}-w_{min}) * \max\,(SOC_i) + (\,1 - w/(w_{max}-w_{min})\,) * \min\,(SOC_i).$$

Vorteilhafterweise erlaubt das erfindungsgemäße Verfahren eine einfache Ermittlung eines einzelnen, repräsentativen und aussagekräftigen Ladezustands für das gesamte Batteriepack. Die einzelnen maximalen und minimalen Ladezustände werden dabei in einer Weise gewichtet, dass für hohe Ladezustände der maximale Einzelzellen-Ladezustand dominiert, für niedrige Ladezustände hingegen der minimale EinzelzellenLadezustand. Dabei erfolgt der Übergang zwischen Minimal- und Maximalwert durch die spezielle Ausgestaltung der Gewichtungsfunktion gw() kontinuierlich und stetig.

Die in den abhängigen Ansprüchen aufgeführten Maßnahmen erlauben vorteilhafte Weiterbildungen und Verbesserungen des im unabhängigen Anspruch angegebenen Verfahrens.

Im Folgenden werden die Ladezustandswerte in einem Bereich von 0-100 verwendet werden, wobei der Wert "0" dem Ladezustand "0%" der vollständigen Entladung entspricht und "100" dem Ladezustand "100%" der vollständigen Aufladung entspricht. Diese Einteilung ist jedoch nicht beschränkend. Es ist für den Fachmann ersichtlich, dass auch ein Wertebereich z.B. von 0-1 verwendet werden kann. Dann sind die unten stehenden Funktionen entsprechend umzuskalieren.

So umfasst die Gewichtungsfunktion gw() in einem ersten Ausführungsbeispiel die Tangens Hyperbolicusfunktion. Bevorzugt gilt für die Gewichtungsfunktion: $gw(SOC) = [\,0,5 * (\,1 + \tanh(\,\alpha * (SOC-50)))]^p$, für alle Ladezustandswerte SOC im Bereich von 0 und 100, und "$\alpha$" variabel mit $\alpha > 0$, und "p" ein Element der natürlichen Zahlen ist.

Die spezielle Ausgestaltung der Gewichtungsfunktion erlaubt einen Übergang von Minimalwert "0" auf den Maximalwert "1" im mittleren Wertebereich des Ladezustands um den Wert "50" herum, der einem Ladezustand von 50% entspricht. Dabei ist die Funktion punktsymmetrisch zu diesem mittleren Wert. Die Variable "$\alpha$" erlaubt die Einstellung der gewünschten Breite des Übergangs zwischen Minimal- und Maximalwert. Ein großer Wert der Variable "$\alpha$" erlaubt einen schnelleren Wechsel zwischen Minimal- und Maximalwert als ein kleinerer Wert. Besonders bevorzugt ist der Exponentialwert p=1. Er kann jedoch auch höher gewählt werden, um wiederum den Wechsel der Gewichtung zwischen maximalen Einzelzellenladezustand und minimalen Einzelzellenladezustand im Gesamtladezustand zu beschleunigen.

In einem zweiten Ausführungsbeispiel umfasst die Gewichtungsfunktion gw() die Sigmoidfunktion. Bevorzugt gilt dann für die Gewichtungsfunktion:

$$gw(SOC) = [\,1 / (1 + e^{-\,\alpha * (SOC-50)})\,]^p,$$

für alle Ladezustandswerte SOC im Bereich von 0 und 100, und "$\alpha$" variabel mit $\alpha > 0$, und "p" ein Element der natürlichen Zahlen ist.

Die Sigmoidfunktion hat gegenüber dem Tangens Hyperbolicus den Vorteil, dass ihr Wertebereich unmittelbar zwischen den gewünschten Werten von "0" und "1" variiert und nicht erst verschoben werden muss. Der Tangens Hyperbolicus variiert zwischen den Werten "-1" und "1". Die spezielle Ausgestaltung der Gewichtungsfunktion erlaubt einen Übergang von Minimalwert "0" auf den Maximalwert "1" im mittleren Wertebereich des Ladezustands mit dem Wert "50", der einem Ladezustand von 50% entspricht. Dabei ist die Funktion punktsymmetrisch zu diesem mittleren Wert. Die Variable "$\alpha$" erlaubt die Einstellung der gewünschten Breite des Übergangs zwischen Minimal- und Maximalwert. Ein großer Wert der Variable "$\alpha$" erlaubt einen schnelleren Wechsel zwischen Minimal- und Maximalwert als ein kleinerer Wert. Besonders bevorzugt ist der Exponentialwert p=1. Er kann jedoch auch höher gewählt werden, um wiederum den Wechsel der Gewichtung zwischen maximalen Einzelzellenladezustand und minimalen Einzelzellenladezustand im Gesamtladezustand zu beschleunigen.

In einem dritten Ausführungsbeispiel besteht die Gewichtungsfunktion aus einzelnen linearen Funktion, die für verschiedene Abschnittswerte des Ladezustands definiert sind. Bevorzugt gilt für die Gewichtungsfunktion gw(SOC), für alle SOC im Bereich von 0 bis 100:

$$SOC[0;X]: \quad gw(SOC)=0;$$
$$SOC]X;Y]: \quad gw(SOC)=(SOC-X)/(Y-X);$$
$$SOC]Y;100]: \quad gw(SOC)=1.$$

Die spezielle Ausgestaltung der Gewichtungsfunktion als abschnittsweise lineare Funktion erlaubt ein sehr einfache Implementierung der Anforderungen an die Gewichtungsfunktion. Die Größe der Ladezustandswerte X und Y bestimmt dabei die Lage und Größe des Übergangs zwischen Minimal- und Maximalwert.

Bevorzugt werden die Werte X und Y symmetrisch um den mittleren Ladezustand herum gewählt werden. Dies erlaubt eine plausible Darstellung und Ausgabe des Ladezustandswertes.

In einem bevorzugten Ausführungsbeispiel entspricht der Wert X einem Ladezustand von 20%, es gilt also X=20. Der Wert Y entspricht dabei einem Ladezustand von 80%, also gilt Y=80 ist. Dies gewährleistet eine linear abnehmende oder zunehmende Darstellung des Ladezustands im mittleren Bereich, wobei die Extrembereiche von vollständiger Entladung und Aufladung bereits frühzeitig als solche ausgegeben werden, um Gefahren zu vermeiden. Natürlich können bei entsprechender Umskalierung auch Werte zwischen 0 und 1 statt 0 und 100 verwendet werden. Auch kann direkt ein Prozentwert verwendet werden, wiederum bei entsprechender Umskalierung der Gleichungen.

Es wird ebenfalls ein Computerprogramm angegeben, das alle Schritte eines oben beschriebenen Verfahrens ausführt, wenn es auf einem Rechengerät, wie einer Kontrolleinheit eines Batteriepacks abläuft. Die Kontrolleinheit kann auch getrennt vom Batteriepack angeordnet sein.

Ebenso wird ein Batteriemanagementsystem, insbesondere für Li-Ionen Batterien vorgeschlagen, wobei das Batteriesystem das obige Verfahren zur Bestimmung des Ladezustands umfasst.

Entsprechend wird ein Batteriesystem angegeben, welches ein Li-Ionen-Batteriepack bestehend aus einer Mehrzahl von einzelnen Batteriezellen und ein Batteriemanagementsystem für Li-Ionen Batterien umfasst, wobei das Batteriesystem das obige Verfahren zur Bestimmung des Ladezustands umfasst.

Des Weiteren wird ein Kraftfahrzeug angegeben, welches mit einem Antriebssystem ausgerüstet ist, das ein entsprechendes erfindungsgemäßes Batteriesystem umfasst.

Ausführungsbeispiele der Erfindung sind in den Zeichnungen dargestellt und in der nachfolgenden Beschreibung näher erläutert.

Es zeigen:

Figur 1      ein Flussdiagram des erfindungsgemäßen Verfahrens,

Figur 2      ein Graph der Gewichtungsfunktion gemäß eines ersten Ausführungsbeispiels der Erfindung,

Figur 3      der Ladezustand des Batteriepacks, welcher nach dem ersten Ausführungsbeispiel der Erfindung berechnet wurde,

Figur 4      ein Graph der Gewichtungsfunktion gemäß eines dritten Ausführungsbeispiels der Erfindung,

Figur 5      der Ladezustand des Batteriepacks, welcher nach dem dritten Ausführungsbeispiel der Erfindung berechnet wurde.

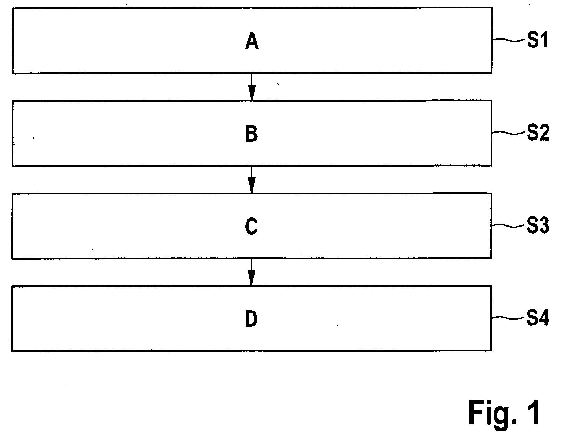

In der Figur 1 ist ein Flussdiagramm des erfindungsgemäßen Verfahrens zur Bestimmung des Ladezustands eines Batteriepacks gezeigt. Das Batteriepack besteht im folgenden bevorzugt aus Li-Ionen Batteriezellen, kann aber auch auf andere Batterietypen bestehend aus mehreren elektrochemischen Zellen angewandt werden.

In Fig. 1 steht der Platzhalter "A" für die "Bestimmung von $SOC_i$ für alle i=1,N", der Platzhalter "B" steht für die "Bestimmung des Mittelwertes mean($SOC_i$) aller $SOC_i$", der Platzhalter "C" steht für "Bestimmung einer Gewichtung w=gw(mean($SOC_i$)) mit gw(SOC): gw(SOC→0%)→ 0; gw(SOC →100 %)→ 1; und gw() stetig", der Platzhalter "D" steht für die "Bestimmung des Gesamtladezustands des Batteriepacks $SOC_p$ mit: $SOC_p = w * \max(SOC_i) + (1-w) * \min(SOC_i)$".

Das erfindungsgemäße Verfahren zur Ermittlung des Ladezustands bezieht sich auf ein Batteriepack bestehend aus einer Anzahl "N" von einzelnen Batteriezellen.

In einem ersten Schritte wird der Ladezustand jeder einzelnen Batteriezelle $SOC_i$ für alle i=1,N bestimmt, wobei der Batterieladezustand zwischen einem minimalen Ladezustand der vollständigen Entladung $SOC_{min}$ und einem maximalen Ladezustand der vollständigen Aufladung $SOC_{max}$ variiert. Der minimale Ladezustand kann beispielsweise den Wert "0" oder "0%"haben, der maximale Ladezustand den Wert "1" oder "100" oder "100%".

In einem zweiten Schritt wird der Mittelwert der Ladezustände der einzelnen Batteriezellen $mean(SOC_i)$ bestimmt. Der Mittelwert berechnet sich üblicherweise aus: $mean(SOCi) = 1/N * \Sigma_{i=1,N} SOC_i$.

Es folgt im dritten Schritt das Bestimmen einer Gewichtung "w" des maximalen Batterieladezustandes einer Batteriezelle des Batteriepacks $max(SOC_i)$ bzw. einer Gewichtung (1-w) des minimalen Batterieladezustandes einer Batteriezelle des Batteriepacks $(min(SOC_i))$ aus der Gleichung mit $w = gw(mean(SOC_i))$, wobei für die Funktion gw(SOC) gilt:

der Funktionswert strebt gegen einen Minimalwert von "0", wenn sein Argument gegen den minimalen Ladezustand der vollständigen Entladung $SOC_{min}$ strebt;
der Funktionswert strebt gegen einen Maximalwert von "1", wenn sein Argument gegen den maximalen Ladezustand der vollständigen Aufladung $SOC_{max}$ strebt; und
die Funktion gw() ist stetig.

Mit anderen Worten, zur Gewichtung wird eine mathematische Funktion $gw = f(SOC)$ in Abhängigkeit des Ladezustands SOC verwendet, die folgende Eigenschaften aufweist:

$$- gw\,(SOC \rightarrow 0\%) \rightarrow 0 \qquad (1),$$
$$- gw\,(SOC \rightarrow 100\,\%) \rightarrow 1 \qquad (2),$$
$$- gw()\ \text{ist stetig} \qquad (3).$$

Im obigen Beispiel wurde $w_{max}=1$ und $w_{min}=0$ gesetzt. Hierbei ist wiederum für den Fachmann klar, dass die Werte von Minimalwert "0" und Maximalwert "1" nicht beschränkend sind, sondern auch andere Werte wie "0%" für den Minimalwert oder "100%" oder "100" für den Maximalwert verwendet werden können.

Abschliessend wird in einem vierten Schritt der Ladezustands des gesamten Batteriepacks $SOC_p$ als Funktion des Wertes der Gewichtung w, des maximalen Batterieladezustands einer Batteriezelle des Batteriepacks $max(SOC_i)$ und des minimalen Batterieladezustands einer Batteriezelle des Batteriepacks $min(SOC_i)$ berechnet. Dies erfolgt gemäß der Gleichung:

$$SOC_p = w * max(SOC_i) + (1-w) * min(SOC_i). \qquad (4)$$

Diese Gleichung gilt wiederum nicht beschränkend für $w_{max}=1$ und $w_{min}=0$.

Der letzte Schritt kann auch wie folgt beschrieben werden: Die Bestimmung des Ladezustands des gesamten Batteriepacks $SOC_p$ erfolgt als Funktion des Wertes der Gewichtung w, des maximale Batterieladezustandes einer Batteriezelle des Batteriepacks $max(SOC_i)$ und des minimalen Batterieladezustand einer Batteriezelle des Batteriepacks $min(SOC_i)$, wobei gilt $SOC_p \leq max(SOC_i)$, für die Gewichtung "w" strebend gegen ihren Maximalwert; und $SOC_p \geq min(SOC_i)$, für die Gewichtung "w" strebend gegen ihren Minimalwert. Der Ladezustands des gesamten Batteriepacks $SOC_p$ kann als lineare Regression aus dem Wert der Gewichtung w, dem maximale Batterieladezustand einer Batteriezelle des Batteriepacks $max(SOC_i)$ und dem minimalen Batterieladezustand einer Batteriezelle des Batteriepacks $min(SOC_i)$ berechnet werden.

In einem ersten Ausführungsbeispiel ist eine vorteilhaft anwendbare Funktion für die Gewichtungsfunktion:

$$gw(SOC) = 0{,}5 * (1 + tanh(\alpha * (SOC-50\%))) \qquad (5).$$

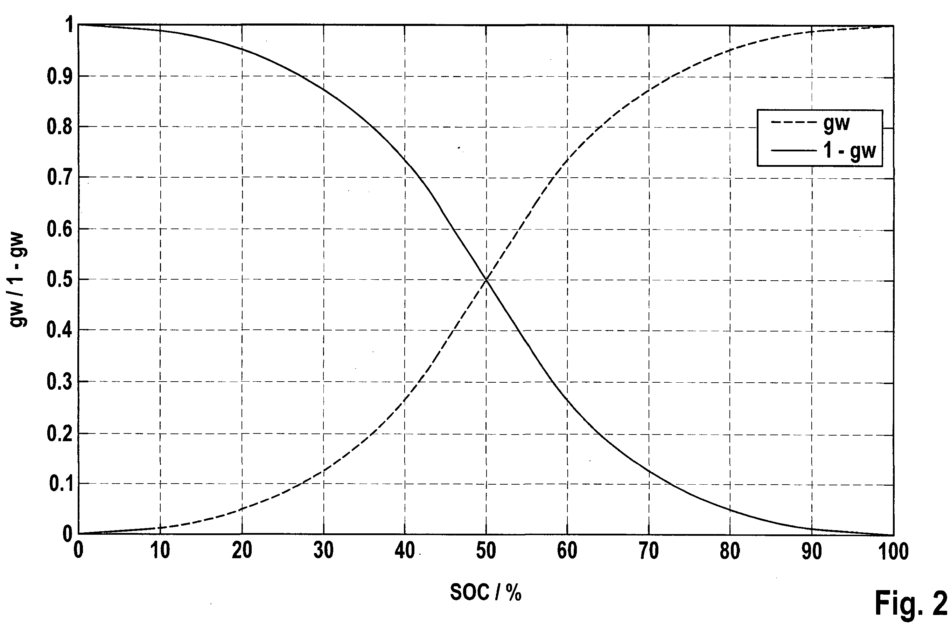

Diese erfüllt die gegebenen Anforderungen und weist einen Übergang vom Minimalwert "0" auf den Maximalwert "1" im Bereich um 50% SOC auf. Die Breite dieses Übergangs ist über den Parameter $\alpha$ einstellbar. Beispielsweise ergibt sich für $\alpha = 1/20$ der in Fig. 2 dargestellte Verlauf für die Funktion gw(SOC). Die Abbildung stellt zusätzlich den Verlauf von 1-gw(SOC) dar. Die Funktion kann wegen ihres charakteristischen Verlaufs auch "S"-Funktion oder Fermifunktion genannt werden. Ein größerer Wert von "$\alpha$" ergibt dabei einen schnelleren Übergang zwischen Minimal- und Maximalwert.

Mit Hilfe dieser Funktion $gw_1(SOC)$ wird die Berechnung des Gesamtpack-SOC $SOC_p$ aus den einzelnen $SOC_i$ der Zeilen wie folgt vorgenommen:

$$w = gw_1(mean(SOC_i)), \qquad\qquad (6)$$

$$SOC_p = w * max(SOC_i) + (1-w) \, min(SOC_i), \qquad\qquad (7)$$

wobei $mean(SOC_i)$ der Mittelwert, $max(SOC_i)$ der Maximalwert und $min(SOC_i)$ der Minimalwert der einzelnen Zell-SOCs ist.

Im obigen Ausführungsbeispiel kann die Gewichtungsfunktion auch das Quadrat oder eine andere Potenz der Gleichung (5) sein. Die Wahl der Potenz erlaubt wiederum einen schnelleren Übergang der Gewichtung von maximalen und minimalen Einzelladezustand im Gesamtpackladezustand.

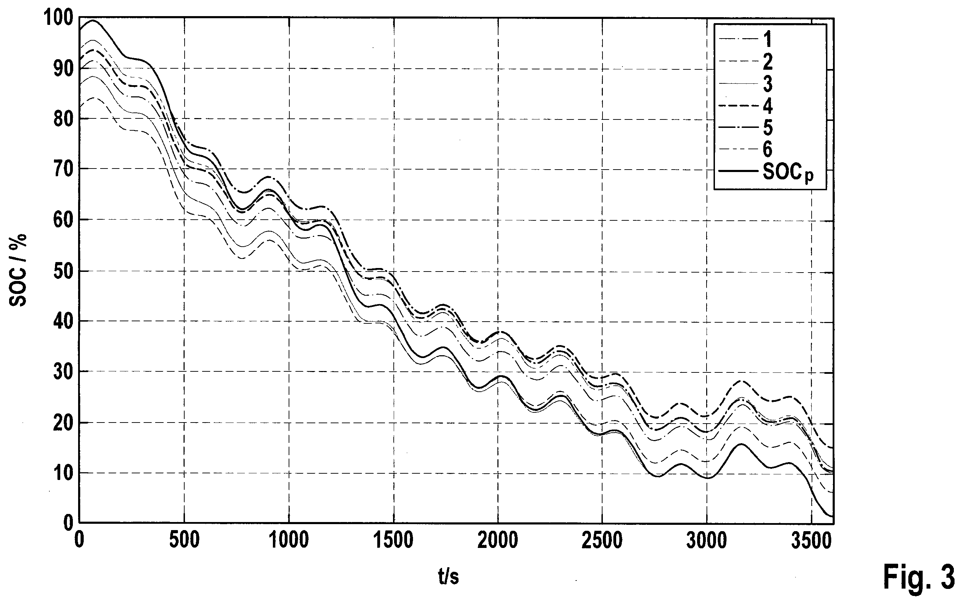

Figur 3 stellt eine beispielhafte Anwendung der Gleichungen (5) bis (7) dar und zeigt Ladekurven in Prozent. Das Batteriepack besteht dabei aus 6 Einzelzellen, deren Ladezustände um etwa +/- 10% variieren und in Fig. 3 mit den Ziffern "1" bis "6" bezeichnet werden. Die Kurve für die Ziffer "1" entspricht also dem Ladezustand der Batteriezelle 1. Ferner ist die Kurve für den Gesamtladezustand, bezeichnet mit $SOC_p$ dargestellt. Zu Beginn des dargestellten zeitlichen Verlaufs erreicht Zelle 5 einen Ladezustand von nahezu 100%. Der ermittelte Gesamtladezustand $SOC_p$ nimmt diesen Maximalwert an. Nach etwa 1300 Sekunden liegt der mittlere Ladezustand bei etwa 50%. Der Gesamtpackladezustand $SOC_p$ entspricht dem Mittelwert zwischen maximalem und minimalem Einzelzellenladezustand. Im weiteren Verlauf sinken die Einzelzellenladezustände weiter ab, so dass der Gesamtpackladezustand $SOC_p$ den Ladezustandswert der niedrigsten Zelle, im Beispiel Zelle 3, annimmt.

In einem zweiten Ausführungsbeispiel (nicht in den Figuren gezeigt) wird die Gewichtungsfunktion aus einer Sigmoidfunktion gebildet, bevorzugt aus

$$gw(SOC) = [\ 1\ /\ (1 + e^{-\alpha * (SOC-50)})\ ]^p, \qquad\qquad (8)$$

für alle Ladezustandswerte SOC im Bereich von 0 und 100, und "$\alpha$" variabel mit $\alpha > 0$, und "p" ein Element der natürlichen Zahlen ist. Wiederum erlauben die Parameter "p" und "$\alpha$" je nach Größe einen schnelleren oder langsameren Übergang von minimalen und maximalen Wert der Gewichtungsfunktion. Die Sigmoidfunktion hat gegenüber dem Tangens Hyperbolicus den Vorteil, dass sie bereits den gewünschten Wertebereich zwischen "0" und "1" liefert, während die Tangens Hyperbolicusfunktion erst verschoben werden muss. Da die Funktionen ansonsten sehr ähnlich sind, wird auf eine weitere Darstellung der Gewichtungsfunktion und des daraus resultierenden Gesamtpackladezustands $SOC_p$ verzichtet.

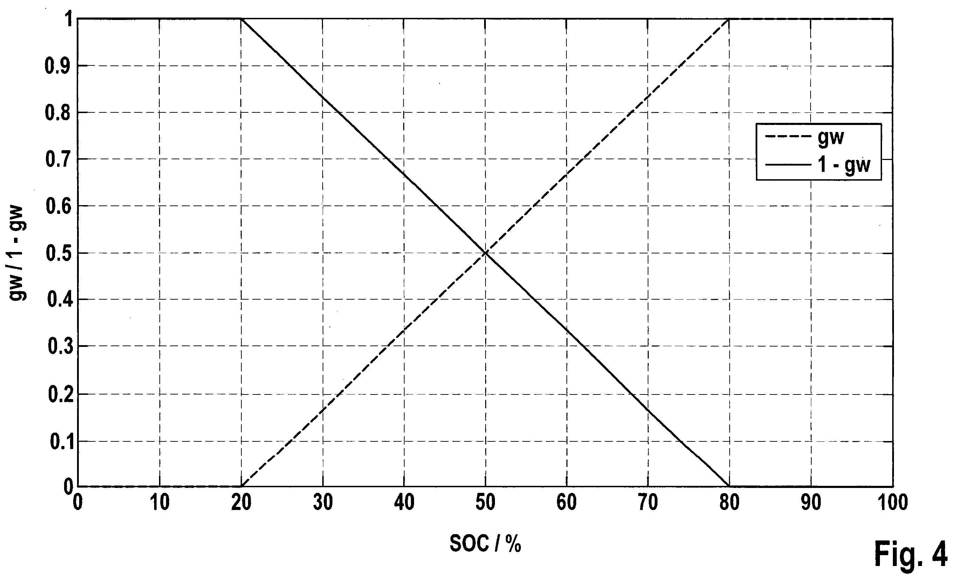

Figur 4 zeigt eine alternative Gewichtungsfunktion gw und gleichzeitig den Wert von 1-gw. Hier wurde die Gewichtungsfunktion gw wie folgt gewählt:

$$SOC\ [0\text{-}20\%]: \qquad gw\ (SOC) = 0 \qquad\qquad (9),$$

$$SOC\ [20\text{-}80\%]: \qquad gw\ (SOC) = (SOC\text{-}20)*1/60 \qquad\qquad (10),$$

$$SOC\ [80\%\text{-}100\%]: \qquad gw\ (SOC) = 1 \qquad\qquad (11).$$

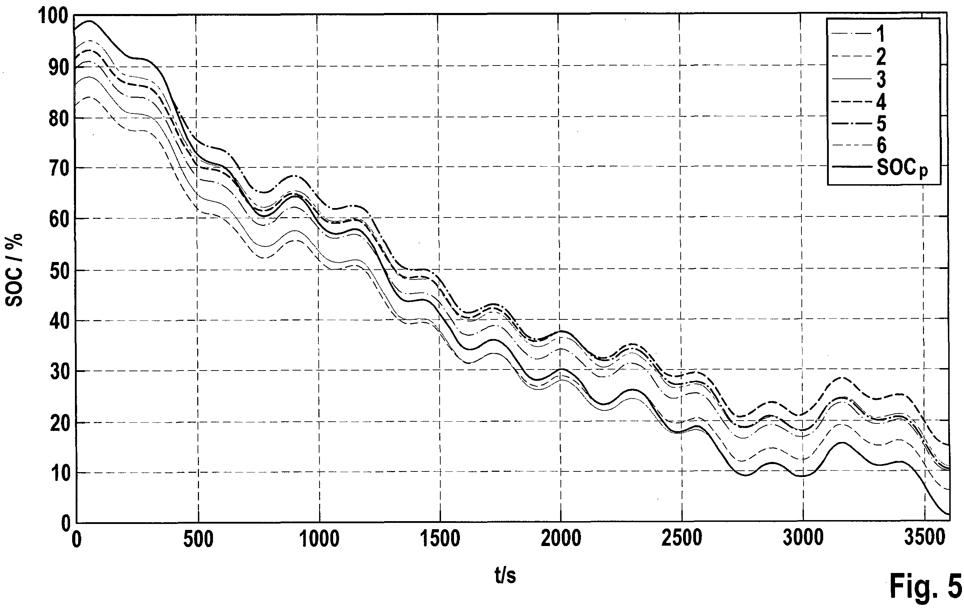

Diese Funktion erfüllt ebenfalls die in geforderten Anforderungen an die Gewichtungsfunktion. Fig. 5 stellt wiederum die Ladekurven in Prozent für sechs Einzelzellen und den Gesamtpack $SOC_p$ dar. Wie die Figur verdeutlicht, ist auch die geänderte Gewichtungsfunktion gw zur Bestimmung des Gesamtpack-SOC $SOC_p$ geeignet. Wiederum dominiert für hohe Ladezustände der maximale Einzelladezustand und für niedrige Ladezustände der minimale Ladezustand, wobei der Übergang stetig verläuft.

Allgemein können in den Gleichungen (9)-(11) die Unter- und Oberwerte des mittleren Bereichs variieren und einen Wert von x% und y% annehmen, wobei für die untere und obere Schranke gilt: $0 < x < 50$ und $50 < y < 100$:

$$SOC[0;X]: \qquad gw(SOC)=0; \qquad (12)$$
$$SOC]X;Y]: \qquad gw(SOC)=(SOC\text{-}X)/(Y\text{-}X)\ ; \qquad (13)$$
$$SOC]Y;100]: \qquad gw(SOC)=1. \qquad (14)$$

Der mittlerere Bereich wird dabei immer symmetrisch zum mittleren Wert des Ladezustandes 50% gewählt. Je nach Wahl von unterer und oberer Schranke erfolgt dabei der Übergang der Gewichtungsfunktion zwischen ihrem Minimal- und dem Maximalwert schneller (relativ kleine Differenz von x und y) oder langsamer (relativ große Differenz von x und y). Obiges Beispiel gilt wiederum nicht beschränkend für die Minimal- und Maximalwerte "0" und "1" der Gewichtung. Diese können bei entsprechender Umskalierung der Funktion (7) auch anders gewählt werden.

Das Verfahren wird bevorzugt in einem Batteriemanagementsystem für Li-Ionen Batteriepacks verwendet.

In einem besonders bevorzugten Ausführungsbeispiel wird das Batteriemanagementsystem in einer Li-Ionen-Batterie eingesetzt, die als Antrieb eines Kraftfahrzeuges dient. Das Batteriemanagementsystem kann dabei in einer Kontrolleinheit des Fahrzeugs ablaufen.

**Patentansprüche**

1. Verfahren zur Ermittlung des Ladezustands eines Batteriepacks bestehend aus einer Anzahl "N" von einzelnen Batteriezellen, umfassend die Schritte:

   (S1) Bestimmen des Ladezustands jeder einzelnen Batteriezelle ($SOC_i$) (S1) für alle i=1,N, wobei der Batterieladezustand zwischen einem minimalen Ladezustand der vollständigen Entladung ($SOC_{min}$) und einem maximalen Ladezustand der vollständigen Aufladung ($SOC_{max}$) variiert;
   (S2) Bestimmen des Mittelwertes der Ladezustände der einzelnen Batteriezellen ($mean(SOC_i)$);
   **gekennzeichnet durch**
   (S3) Bestimmen einer Gewichtung (w) des maximalen Batterieladezustands einer Batteriezelle des Batteriepacks ($max(SOC_i)$) bzw. einer Gewichtung (1-w) des minimalen Batterieladezustands einer Batteriezelle des Batteriepacks ($min(SOC_i)$) mit:

$$w = gw(mean(SOC_i)),$$

   wobei für die Funktion gw(SOC) gilt:

   - der Funktionswert strebt gegen einen Minimalwert von "$w_{min}$" (z.B. 0 bzw. 0%), wenn sein Argument gegen den minimalen Ladezustand der vollständigen Entladung ($SOC_{min}$=0 bzw. 0%) strebt;
   - der Funktionswert strebt gegen einen Maximalwert von "$w_{max}$" (z.B. 1 bzw. 100%), wenn sein Argument gegen den maximalen Ladezustand der vollständigen Aufladung ($SOC_{max}$=1 bzw. 100%) strebt; und
   - die Funktion gw() ist stetig;

   (S4) Bestimmung des Ladezustands des gesamten Batteriepacks ($SOC_p$) als Funktion des Wertes der Gewichtung (w), des maximalen Batterieladezustands einer Batteriezelle des Batteriepacks ($max(SOC_i)$) und des minimalen Batterieladezustands einer Batteriezelle des Batteriepacks ($min(SOC_i)$) gemäß:

$$SOC_p = w/(w_{max}-w_{min}) * max(SOC_i) + (1 - w/(w_{max}-w_{min})) * min(SOC_i).$$

2. Verfahren nach Anspruch 1, wobei die Gewichtungsfunktion gw(SOC):

   - den Tangens Hyperbolicus umfasst; oder
   - die Sigmoidfunktion umfasst; oder
   - eine abschnittsweise lineare Funktion ist.

3. Verfahren nach Anspruch 2, wobei für die Gewichtungsfunktion gw(SOC) gilt:

$$gw(SOC) = [0,5 * (1 + tanh(\alpha * (SOC-50)))]^p,$$

   für alle Ladezustandswerte (SOC) im Bereich von 0 und 100, und "$\alpha$" variabel mit $\alpha > 0$, und "p" ein Element der natürlichen Zahlen ist und $w_{max}$=1 und $w_{min}$=0.

4. Verfahren nach Anspruch 2, wobei für die Gewichtungsfunktion gw(SOC) gilt:

$$gw(SOC) = [\ 1\ /\ (1 + e^{-\alpha\,*\,(SOC-50)})\ ]^p$$

für alle Ladezustandswerte (SOC) im Bereich von 0 und 100, und "$\alpha$" variabel mit $\alpha > 0$, und "p" ein Element der natürlichen Zahlen ist und $w_{max}=1$ und $W_{min}=0$.

5. Verfahren nach Anspruch 3 oder 4, wobei p=1.

6. Verfahren nach 2, wobei für die Gewichtungsfunktion gw(SOC) gilt, für alle SOC im Bereich von 0 bis 100:

      - SOC[0;X]:      gw(SOC)=0;
      - SOC]X;Y]:      gw(SOC)=(SOC-X)/(Y-X) ;
      - SOC]Y;100]:      gw(SOC)=1.

7. Verfahren nach Anspruch 6, wobei die Werte X und Y symmetrisch um den mittleren Ladezustand gewählt werden.

8. Verfahren nach Anspruch 6 oder 7, wobei der Wert X einem Ladezustand von 20% mit X=20 entspricht, und Y einem Ladezustand von 80% mit Y=80 entspricht.

9. Computerprogramm, das alle Schritte eines Verfahrens nach einem der Ansprüche 1 bis 8 ausführt, wenn es auf einem Rechengerät abläuft.

10. Batteriesystem, umfassend ein Li-Ionen-Batteriepack bestehend aus einer Mehrzahl von einzelnen Batteriezellen und ein Batteriemanagementsystem für Li-Ionen Batterien, welches ein Verfahren nach einem der Ansprüche 1 bis 8 umfasst.

11. Kraftfahrzeug mit einem Antriebssystem, welches ein Batteriesystem nach Anspruch 10 umfasst.


**Claims**

1. Method for determination of the state of charge of a battery pack consisting of a number "N" of individual battery cells, comprising the following steps:

    (S1) determination of the state of charge of each individual battery cell ($SOC_i$)(S1) for all i=1, N, wherein the battery state of charge varies between a minimum state of charge of complete discharging ($SOC_{min}$) and a maximum state of charge of complete charging ($SOC_{max}$);
    (S2) determination of the mean value of the states of charge of the individual battery cells (mean($SOC_i$));
    **characterized by**
    (S3) determination of a weighting (w) of the maximum battery state of charge of a battery cell in the battery pack (max($SOC_i$)) and/or of a weighting (1-w) of the minimum battery state of charge of a battery cell in the battery pack (min($SOC_i$)), where:

$$w=gw(mean(SOC_i))$$

    wherein, for the function gw(SOC):

      - the function value tends to a minimum value of "$w_{min}$" (for example 0 or 0%) when its argument tends to the minimum state of charge of complete discharge ($SOC_{min}$ 0 or 0% );
      - the function value tends to a maximum value of "$w_{max}$" (for example 1 or 100%) when its argument tends to the maximum state of charge of complete charge ($SOC_{max}$ 1 or 100%); and
      - the function gw() is continuous;

(S4) determination of the state of charge of the overall battery pack ($SOC_p$) as a function of the value of the weighting (w), of the maximum battery state of charge of a battery cell in the battery pack ($max(SOC_i)$) and of the minimum battery state of charge of a battery cell in the battery pack ($min(SOC_i)$) in accordance with:

$$SOC_p = w/(w_{max}-w_{min}) * max(SOC_i) + (1-w/(w_{max}-w_{min})) * min(SOC_i).$$

2. Method according to Claim 1, wherein the weighting function gw(SOC):

- comprises the hyperbolic tangent; or
- comprises the sigmoid function; or
- is a function which is linear in places.

3. Method according to Claim 2, wherein, for the weighting function gw(SOC):

$$gw(SOC) = [0.5*(1 + tanh(\alpha*(SOC-50)))]^p,$$

for all state of charge values (SOC) in the range from 0 to 100, and "$\alpha$" is variable where $\alpha>0$, and "p" is an element of the natural numbers and $w_{max}=1$ and $w_{min}=0$.

4. Method according to Claim 2, wherein, for the weighting function gw(SOC):

$$gw(SOC) = [1/(1+e^{-\alpha*(SOC-50)})]^p$$

for all state of charge values (SOC) in the range from 0 to 100, and "$\alpha$" is variable where $\alpha>0$, and "p" is an element of the natural numbers and $w_{max}=1$ and $w_{min}=0$.

5. Method according to Claim 3 or 4, wherein p=1.

6. Method according to Claim 2, wherein, for the weighting function gw(SOC), for all SOC in the range from 0 to 100:

- SOC[0;X]:      gw(SOC)=0;
- SOC[X;Y]:      gw(SOC) = (SOC-X)/(Y-X);
- SOC[Y;100]:   gw(SOC)=1.

7. Method according to Claim 6, wherein the values X and Y are chosen to be symmetrical about the mean state of charge.

8. Method according to Claim 6 or 7, wherein the value X corresponds to a state of charge of 20% when X=20, and Y corresponds to a state of charge of 80% when Y=80.

9. Computer program, which carries out all the steps of a method according to one of Claims 1 to 8 when it is run on a computation appliance.

10. Battery system, comprising a lithium-ion battery pack consisting of a plurality of individual battery cells, and a battery management system for lithium-ion batteries, which comprises a method according to one of Claims 1 to 8.

11. Motor vehicle having a drive system which comprises a battery system according to Claim 10.

**Revendications**

1. Procédé de détermination de l'état de charge d'un bloc de batteries composé d'un nombre « N » de cellules de batterie individuelles, comprenant les étapes suivantes :

(S1) détermination de l'état de charge de chaque cellule de batterie individuelle ($SOC_i$) (S1) pour tous les i = 1,N, l'état de charge de batterie variant entre un état de charge minimal de décharge complète ($SOC_{min}$) et un état de charge maximal de charge complète ($SOC_{max}$) ;

(S2) détermination de la valeur moyenne des états de charge des cellules de batterie individuelles ($mean(SOC_i)$) ;

**caractérisé par**

(S3) détermination d'une pondération (w) de l'état de charge de batterie maximal d'une cellule de batterie du bloc de batteries ($max(SOC_i)$) ou d'une pondération (1-w) de l'état de charge de batterie minimal d'une cellule de batterie du bloc de batteries ($min(SOC_i)$), avec :

$$w = gw(mean(SOC_i)),$$

où les règles suivantes s'appliquent pour la fonction gw ( SOC ) :

- la valeur de la fonction tend vers une valeur minimale de « $w_{min}$ » (par exemple 0 ou 0 %) lorsque son argument tend vers l'état de charge minimal de décharge complète ( $SOC_{min}$ = 0 ou 0 %) ;
- la valeur de la fonction tend vers une valeur maximale de « $w_{max}$ » (par exemple 1 ou 100 %) lorsque son argument tend vers l'état de charge maximal de charge complète ($SOC_{max}$ = 1 ou 100 %) ; et
- la fonction gw() est continue ;

(S4) détermination de l'état de charge de l'ensemble du bloc de batteries ($SOC_p$) en fonction de la valeur de la pondération (w), de l'état de charge de batterie maximal d'une cellule de batterie du bloc de batteries ($max(SOC_i)$) et de l'état de charge de batterie minimal d'une cellule de batterie du bloc de batteries ($min(SOC_i)$) conformément à :

$$SOC_p = w/(w_{max}-w_{min}) * max(SOC_i) + (1 - w/(w_{max}-w_{min})) * min(SOC_i).$$

2. Procédé selon la revendication 1, la fonction de pondération gw(SOC) :

- comprenant la tangente hyperbolique ; ou
- comprenant la fonction sigmoïde ; ou
- étant une fonction linéaire dans certaines portions.

3. Procédé selon la revendication 2, la règle suivante s'appliquant à la fonction de pondération gw ( SOC ) :

$$gw(SOC) = [0,5 * (1 + tanh(\alpha * (SOC-50)))]^p,$$

pour toutes les valeurs d'état de charge (SOC) dans la plage de 0 à 100, et « $\alpha$ » étant une variable avec $\alpha > 0$ et « p » un élément des nombres naturels et $w_{max}$ = 1 et $W_{min}$ = 0.

4. Procédé selon la revendication 2, la règle suivante s'appliquant à la fonction de pondération gw ( SOC ) :

$$gw(SOC) = [1 / (1 + e^{-\alpha*(SOC-50)})]^p,$$

pour toutes les valeurs d'état de charge (SOC) dans la plage de 0 à 100, et « $\alpha$ » étant une variable avec $\alpha > 0$ et « p » un élément des nombres naturels et $w_{max}$ = 1 et $W_{min}$ = 0.

5. Procédé selon la revendication 3 ou 4, avec p = 1.

6. Procédé selon la revendication 2, la règle suivante s'appliquant à la fonction de pondération gw(SOC) pour tous les SOC dans la plage de 0 à 100 :

- SOC[0;X] :        gw(SOC) = 0 ;
- SOC[Y;X] :        gw(SOC) = (SOC-X)/(Y-X) ;
- SOC[Y;100] :      gw(SOC) = 1.

7. Procédé selon la revendication 6, les valeurs X et Y étant choisies symétriquement autour de l'état de charge médian.

8. Procédé selon la revendication 6 ou 7, la valeur X correspondant à un état de charge de 20 % avec X = 20 et Y à un état de charge de 80 % avec Y = 80.

9. Programme informatique qui exécute toutes les étapes d'un procédé selon l'une des revendications 1 à 8 lorsqu'il est exécuté sur un ordinateur.

10. Système de batterie, comprenant un bloc de batteries aux ions de lithium constitué d'une pluralité de cellules de batterie individuelles et d'un système de gestion de batterie pour les batteries aux ions de lithium, lequel comprend un procédé selon l'une des revendications 1 à 8.

11. Véhicule automobile équipé d'un système de propulsion qui comprend un système de batterie selon la revendication 10.

Fig. 1

**Fig. 2**

EP 2 513 659 B1

Fig. 3

SOC / %

t/s

Legend: 1, 2, 3, 4, 5, 6, SOC_p

14

Fig. 4

Fig. 5

EP 2 513 659 B1

**EP 2 513 659 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20090189613 A1
- US 20060091863 A